# EUROPEAN PATENT APPLICATION

(11) **EP 4 693 901 A1**
(43) Date of publication of application: **11.02.2026**
(21) Application number: 24791706.5
(22) Date of filing: 02.02.2024
(51) Int. Cl.: H03H 9/60

(54) **FILTER CIRCUIT, RADIO-FREQUENCY FRONT-END CIRCUIT, RADIO-FREQUENCY CHIP, AND ELECTRONIC DEVICE**

(30) Priority: 20.04.2023 CN 202310436775
(71) Applicant: Huawei Technologies Co., Ltd., Shenzhen, Guangdong 518129 (CN)
(72) Inventor: ZHANG, Benfeng, Shenzhen, Guangdong 518129 (CN); HOU, Hangtian, Shenzhen, Guangdong 518129 (CN); JIA, Huayong, Shenzhen, Guangdong 518129 (CN)
(74) Representative: Gill Jennings & Every LLP
(86) International application number: PCT/CN2024/075555
(87) International publication number: WO 2024/217118

(57) **Abstract**

This application provides a filter circuit, a radio frequency front-end circuit, a radio frequency chip, and an electronic device, to increase an equivalent electromechanical coupling coefficient of the filter circuit. This further increases bandwidth of the filter circuit, and reduces an insertion loss of the filter circuit. The filter circuit may include a plurality of parallel resonant branches, a plurality of series resonators, and a first inductor. The plurality of parallel resonant branches and the plurality of series resonators may be disposed based on a ladder topology. Each parallel resonant branch may include at least one parallel resonator. The first inductor may be connected in parallel to at least two adjacent series resonators in the plurality of series resonators, or may be connected in parallel to at least one parallel resonator in any parallel resonant branch.

## Description

This application claims priority to Chinese Patent Application No. 202310436775.2, filed with the China National Intellectual Property Administration on April 20, 2023 and entitled "FILTER CIRCUIT, RADIO FREQUENCY FRONT-END CIRCUIT, RADIO FREQUENCY CHIP, AND ELECTRONIC DEVICE", which is incorporated herein by reference in its entirety.

### TECHNICAL FIELD

This application relates to the field of signal processing technologies, and more specifically, to a filter circuit, a radio frequency front-end circuit, a radio frequency chip, and an electronic device.

### BACKGROUND

As radio frequency technologies rapidly develop, processing such as filtering of a radio frequency signal becomes particularly important. A filter circuit including a resonator may filter a radio frequency signal. However, communication bandwidth becomes wider as 5G communication technologies develop. Because bandwidth and an insertion loss of the filter circuit are in a positive correlation with an electromechanical coupling coefficient of the resonator, the resonator needs to have a large electromechanical coupling coefficient to increase the bandwidth of the filter circuit and reduce the insertion loss of the filter circuit. However, limited by a material and a processing technology, it is difficult to greatly increase the electromechanical coupling coefficient of the resonator, failing to meet a requirement of the filter circuit.

Therefore, a technical solution that can increase the bandwidth of the filter circuit and reduce the insertion loss of the filter circuit is urgently needed.

### SUMMARY

This application provides a filter circuit, a radio frequency front-end circuit, a radio frequency chip, and an electronic device, to increase an equivalent electromechanical coupling coefficient of the filter circuit. This further increases bandwidth of the filter circuit, and reduces an insertion loss of the filter circuit.

According to a first aspect, this application provides a filter circuit. The filter circuit may include a plurality of parallel resonant branches, a plurality of series resonators, and a first inductor. The plurality of series resonators may be sequentially connected in series, to form a series resonant branch. Each of the plurality of parallel resonant branches may include at least one parallel resonator. In this application, the resonator in the series resonant branch is defined as a series resonator, and the resonator in the parallel resonant branch is defined as a parallel resonator.

Optionally, the plurality of parallel resonant branches and the plurality of series resonators may be disposed based on a ladder topology. The first inductor may be connected in parallel to at least two adjacent series resonators in the plurality of series resonators. In other words, there are at least two series resonators connected in parallel to the first inductor, and the first inductor is bridged between two ends of the at least two series resonators. Alternatively, the first inductor may be connected in parallel to at least one parallel resonator in any one of the plurality of parallel resonant branches.

In the filter circuit provided in this application, the plurality of parallel resonant branches and the plurality of series resonators may be disposed based on the ladder topology, and each parallel resonant branch may include at least one parallel resonator. The first inductor is connected in parallel to the at least two adjacent series resonators, to increase an equivalent electromechanical coupling coefficient of the series resonant branch. The first inductor is connected in parallel to the at least one parallel resonator in the any parallel resonant branch, to increase an electromechanical coupling coefficient of the parallel resonant branch. An electromechanical coupling coefficient of the entire filter circuit is increased as the equivalent electromechanical coupling coefficient of the series resonant branch or the electromechanical coupling coefficient of the parallel resonant branch is increased, to further increase bandwidth of the filter circuit, and reduce an insertion loss of the filter circuit.

In a possible implementation, a first end of each of the plurality of parallel resonant branches may be electrically connected to one series resonator or two adjacent series resonators in the plurality of series resonators, and a second end of each parallel resonant branch may be electrically connected to a ground end.

For example, the first end of the parallel resonant branch may be electrically connected to only a first or last series resonator in the series resonant branch. In other words, the first end of the parallel resonant branch may be electrically connected to one of the plurality of series resonators.

For another example, the first end of the parallel resonant branch may be electrically connected to the two adjacent series resonators in the series resonant branch. In other words, the first end of the parallel resonant branch may be electrically connected to two of the plurality of series resonators.

It may be understood that any two adjacent series resonators in the plurality of series resonators may be electrically connected by using a first node. Therefore, it may be understood that the parallel resonant branch may be electrically connected between the first node and the ground end.

In another possible implementation, the parallel resonant branch may be electrically connected between two adjacent series resonators that are in the plurality of series resonators and that are connected in parallel to the first inductor. Because the two adjacent series resonators are electrically connected by using the first node, it may also be understood that in the plurality of series resonators, the parallel resonant branch is electrically connected to the first node between the two adjacent series resonators that are connected in parallel to the first inductor. The parallel resonant branch not only improves a degree of freedom of the filter circuit, but also prevents two adjacent series resonators from being equivalent to one series resonator, to further increase the bandwidth of the filter circuit, and reduce the insertion loss of the filter circuit.

In another possible implementation, each parallel resonant branch may include a plurality of parallel resonators, and the plurality of parallel resonators may be sequentially connected in series, to form the parallel resonant branch. The plurality of parallel resonators connected in series can increase an equivalent electromechanical coupling coefficient of the parallel resonant branch, to further increase the bandwidth of the filter circuit, and reduce the insertion loss of the filter circuit.

For example, the first inductor may be connected in parallel to at least one of the plurality of parallel resonators. In other words, the first inductor may be connected in parallel to any parallel resonator, or the first inductor may be connected in parallel to at least two parallel resonators. Any one of the at least two parallel resonators may be a parallel resonator electrically connected to the first node, or may be a parallel resonator electrically connected to the ground end. The first inductor is connected in parallel to at least one parallel resonator, to increase the equivalent electromechanical coupling coefficient of the parallel resonant branch. Therefore, the electromechanical coupling coefficient of the entire filter circuit is increased, to further increase the bandwidth of the filter circuit, and reduce the insertion loss of the filter circuit.

For another example, the first inductor may be connected in parallel to at least one of the plurality of parallel resonators other than a parallel resonator electrically connected to the ground end. For example, the parallel resonant branch may include N parallel resonators. In this case, there are N-1 parallel resonators other than the parallel resonator electrically connected to the ground end in the N parallel resonators, and the first inductor may be connected in parallel to at least one of the N-1 parallel resonators. In other words, the first inductor may be bridged between two ends of at least one of the N-1 parallel resonators. This can prevent a plurality of parallel resonators connected in parallel to the first inductor from being equivalent to one parallel resonator, to further increase the bandwidth of the filter circuit, and reduce the insertion loss of the filter circuit.

In another possible implementation, the filter circuit provided in this application may further include a second inductor. Similar to the first inductor, the second inductor may be connected in parallel to at least two adjacent series resonators. In other words, there are at least two series resonators connected in parallel to the second inductor, and the second inductor may be bridged between two ends of the at least two series resonators. Alternatively, the second inductor may be connected in parallel to any parallel resonant branch.

The at least two adjacent series resonators that are connected in parallel to the second inductor partially overlap or do not overlap the at least two adjacent series resonators that are connected in parallel to the first inductor.

In the filter circuit provided in this application, the second inductor is connected in parallel to the at least two adjacent series resonators, to increase the equivalent electromechanical coupling coefficient of the series resonant branch. The second inductor is connected in parallel to the any parallel resonant branch, to increase the electromechanical coupling coefficient of the parallel resonant branch. The electromechanical coupling coefficient of the entire filter circuit is increased as the equivalent electromechanical coupling coefficient of the series resonant branch or the electromechanical coupling coefficient of the parallel resonant branch is increased, to further increase the bandwidth of the filter circuit, and reduce the insertion loss of the filter circuit.

For example, the first inductor may be connected in parallel to at least two series resonators, and the second inductor may also be connected in parallel to at least two series resonators. In other words, the first inductor and the second inductor each are connected in parallel to at least two series resonators. It may be understood that, to avoid a short circuit, the first inductor and the second inductor are not electrically connected to a same first node. Both the first inductor and the second inductor may increase the equivalent electromechanical coupling coefficient of the series resonant branch, to increase the electromechanical coupling coefficient of the entire filter circuit. This further increases the bandwidth of the filter circuit, and reduces the insertion loss of the filter circuit.

For another example, the first inductor may be connected in parallel to at least two series resonators, and the second inductor is connected in parallel to any parallel resonant branch. The first inductor may increase the equivalent electromechanical coupling coefficient of the series resonant branch, and the second inductor may increase the electromechanical coupling coefficient of the parallel resonant branch. The electromechanical coupling coefficient of the entire filter circuit is increased as the equivalent electromechanical coupling coefficient of the series resonant branch and the electromechanical coupling coefficient of the parallel resonant branch are increased, to further increase the bandwidth of the filter circuit, and reduce the insertion loss of the filter circuit.

For another example, the first inductor may be connected in parallel to any parallel resonant branch, and the second inductor may be connected in parallel to at least two series resonators. The first inductor may increase the electromechanical coupling coefficient of the parallel resonant branch, and the second inductor may increase the equivalent electromechanical coupling coefficient of the series resonant branch. The electromechanical coupling coefficient of the entire filter circuit is increased as the electromechanical coupling coefficient of the parallel resonator and the equivalent electromechanical coupling coefficient of the series resonant branch are increased, to further increase the bandwidth of the filter circuit, and reduce the insertion loss of the filter circuit.

For another example, the first inductor may be connected in parallel to any parallel resonant branch, and the second inductor may also be connected in parallel to any parallel resonant branch. Both the first inductor and the second inductor may increase the electromechanical coupling coefficient of the parallel resonant branch. The electromechanical coupling coefficient of the entire filter circuit is increased as the electromechanical coupling coefficient of the parallel resonant branch is increased, to further increase the bandwidth of the filter circuit, and reduce the insertion loss of the filter circuit.

Further, the parallel resonator may be electrically connected between two adjacent series resonators that are in the plurality of series resonators and that are connected in parallel to the second inductor. Because the two adjacent series resonators are electrically connected by using the first node, it may also be understood that in the plurality of series resonators, the parallel resonant branch is electrically connected to a first node between the two adjacent series resonators that are connected in parallel to the second inductor. The parallel resonant branch not only improves the degree of freedom of the filter circuit, but also prevents two adjacent series resonators from being equivalent to one series resonator, to further increase the bandwidth of the filter circuit, and reduce the insertion loss of the filter circuit.

For example, the second inductor may be connected in parallel to at least one of the plurality of parallel resonators. In other words, the second inductor may be connected in parallel to any parallel resonator, or the second inductor may be connected in parallel to at least two parallel resonators. Any one of the at least two parallel resonators may be a parallel resonator electrically connected to the first node, or may be a parallel resonator electrically connected to the ground end. The second inductor is connected in parallel to at least one parallel resonator, to increase the equivalent electromechanical coupling coefficient of the parallel resonant branch. Therefore, the electromechanical coupling coefficient of the entire filter circuit is increased, to further increase the bandwidth of the filter circuit, and reduce the insertion loss of the filter circuit.

For another example, the second inductor may be connected in parallel to at least one of the plurality of parallel resonators other than the parallel resonator electrically connected to the ground end. In other words, the second inductor may be connected in series to at least one of the N-1 parallel resonators. In other words, the second inductor may be bridged between at least one of the N-1 parallel resonators. This can prevent a plurality of parallel resonators connected in parallel to the second inductor from being equivalent to one parallel resonator, to further increase the bandwidth of the filter circuit, and reduce the insertion loss of the filter circuit.

In a possible implementation, resonance frequencies of a part or all of the plurality of series resonators are different, to lower a requirement on the resonance frequencies of the plurality of series resonators. This can further reduce production costs of the series resonators, and improve filtering performance of the filter circuit.

In another possible implementation, resonance frequencies of a part or all of the plurality of parallel resonators are different, to lower a requirement on the resonance frequencies of the plurality of parallel resonators. This can further reduce production costs of the parallel resonators, and improve filtering performance of the filter circuit.

In another possible implementation, a resonance frequency of any one of the series resonators may be different from a resonance frequency of any one of the plurality of parallel resonators, to improve filtering performance of a filter circuit 1.

Further, the resonance frequency of any one of the plurality of series resonators may be greater than the resonance frequency of any one of the plurality of parallel resonators, to further improve the filtering performance of the filter circuit 1.

For example, at least one series resonator may be a bulk acoustic wave (bulk acoustic wave, BAW) resonator (which may be referred to as a BAW resonator for short) or a surface acoustic wave (surface acoustic wave, SAW) resonator (SAW resonator). Similarly, at least one parallel resonator may also be a BAW resonator or a SAW resonator, to improve a degree of integration of the filter circuit 1.

For example, all series resonators and all parallel resonators are BAW resonators. In this case, the filter circuit may be referred to as a bulk acoustic wave filter circuit.

For another example, all series resonators and all parallel resonators are SAW resonators. In this case, the filter circuit may be referred to as a surface acoustic wave filter circuit.

According to a second aspect, this application provides a radio frequency front-end circuit, including an amplification circuit and the filter circuit in the first aspect and the possible implementations of the first aspect. The amplification circuit may be electrically connected to the filter circuit.

In a possible implementation, the radio frequency front-end circuit is used as a transmit end, and is configured to transmit a radio frequency signal. An output end of the amplification circuit may be electrically connected to an input end of the filter circuit. The amplification circuit may be configured to amplify the radio frequency signal and transmit the amplified radio frequency signal to the filter circuit. The filter circuit may be configured to filter the amplified radio frequency signal, and output the filtered radio frequency signal.

In another possible implementation, the radio frequency front-end circuit is used as a receiver end, and is configured to receive a radio frequency signal. An output end of the filter circuit may be electrically connected to an input end of the amplification circuit. The filter circuit may be configured to filter the radio frequency signal and transmit the filtered radio frequency signal to the amplification circuit. The amplification circuit may be configured to amplify the filtered radio frequency signal, and output the amplified radio frequency signal.

According to a third aspect, this application provides a radio frequency chip, including an interface and the radio frequency front-end circuit in the second aspect and the possible implementations of the second aspect. The radio frequency front-end circuit may be electrically connected to the interface.

According to a fourth aspect, this application provides an electronic device, including an antenna and the radio frequency chip in the third aspect and the possible implementations of the third aspect. The antenna may be electrically connected to the radio frequency chip.

In a possible implementation, the radio frequency chip is a chip to send a radio frequency signal. A filtered radio frequency signal output by a filter circuit in the radio frequency chip is transmitted by using the antenna.

In another possible implementation, the radio frequency chip is a chip to receive a radio frequency signal. An amplified radio frequency signal output by an amplification circuit in the radio frequency chip is transmitted by using the antenna.

Optionally, the electronic device may be a mobile phone, a notebook computer, a wearable electronic device, a vehicle-mounted device, or the like. A type of the electronic device is not limited in this application.

It should be understood that technical solutions of the second aspect and the third aspect of this application are consistent with the technical solution of the first aspect in this application, and beneficial effect obtained by the aspects and corresponding feasible implementations is similar. Details are not described herein again.

### BRIEF DESCRIPTION OF DRAWINGS

To describe technical solutions in this application or in the conventional technology more clearly, the following briefly describes accompanying drawings used for describing embodiments or the conventional technology. It is clear that the accompanying drawings in the following descriptions show some embodiments of this application, and a person of ordinary skill in the art may still derive other accompanying drawings from these accompanying drawings without creative efforts.
FIG. 1 is a diagram of a structure of a filter circuit 1 according to an embodiment of this application;
FIG. 2 is another diagram of a structure of a filter circuit 1 according to an embodiment of this application;
FIG. 3 is another diagram of a structure of a filter circuit 1 according to an embodiment of this application;
FIG. 4 is another diagram of a structure of a filter circuit 1 according to an embodiment of this application;
FIG. 5 is another diagram of a structure of a filter circuit 1 according to an embodiment of this application;
FIG. 6 is another diagram of a structure of a filter circuit 1 according to an embodiment of this application;
FIG. 7 is another diagram of a structure of a filter circuit 1 according to an embodiment of this application;
FIG. 8 is another diagram of a structure of a filter circuit 1 according to an embodiment of this application;
FIG. 9 is another diagram of a structure of a filter circuit 1 according to an embodiment of this application;
FIG. 10 is another diagram of a structure of a filter circuit 1 according to an embodiment of this application;
FIG. 11 is another diagram of a structure of a filter circuit 1 according to an embodiment of this application;
FIG. 12 is a diagram of phase curves of series resonant branches according to an embodiment of this application;
FIG. 13 is a diagram of admittance curves of series resonant branches according to an embodiment of this application;
FIG. 14 is a diagram of insertion loss curves of series resonant branches according to an embodiment of this application;
FIG. 15 is a diagram of insertion loss curves of filter circuits 1 according to an embodiment of this application;
FIG. 16 is a diagram of insertion loss curves of filter circuits 1 according to an embodiment of this application;
FIG. 17 is a diagram of a structure of a radio frequency front-end circuit 10 according to an embodiment of this application;
FIG. 18 is another diagram of a structure of a radio frequency front-end circuit 10 according to an embodiment of this application;
FIG. 19 is a diagram of a structure of a radio frequency chip 100 according to an embodiment of this application;
FIG. 20 is a diagram of a structure of an electronic device 1000 according to an embodiment of this application; and
FIG. 21 is another diagram of a structure of an electronic device 1000 according to an embodiment of this application.

### DESCRIPTION OF EMBODIMENTS

The following describes technical solutions in this application with reference to accompanying drawings.

In the specification, embodiments, claims, and accompanying drawings of this application, terms such as "first" and "second" are merely used for differentiation and description, but should not be understood as an indication or implication of relative importance or an indication or implication of a sequence. In addition, the terms "include", "have", and any variant thereof are intended to cover non-exclusive inclusion, for example, include a series of steps or units. For example, a method, system, product, or device is not necessarily limited to those steps or units expressly listed, but may include other steps or units not expressly listed or inherent to such a process, method, product, or device.

It should be understood that, in this application, "at least one" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between the associated objects. The expression "at least one of the following items (pieces)" or a similar expression means any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

As radio frequency technologies rapidly develop, processing such as filtering of a radio frequency signal becomes particularly important. A filter circuit including a resonator may filter a radio frequency signal. However, communication bandwidth becomes wider as 5G communication technologies develop. Because bandwidth and an insertion loss of the filter circuit are in a positive correlation with an electromechanical coupling coefficient of the resonator, the resonator needs to have a large electromechanical coupling coefficient to increase the bandwidth of the filter circuit and reduce the insertion loss of the filter circuit. However, limited by a material and a processing technology, it is difficult to greatly increase the electromechanical coupling coefficient of the resonator, failing to meet a requirement of the filter circuit.

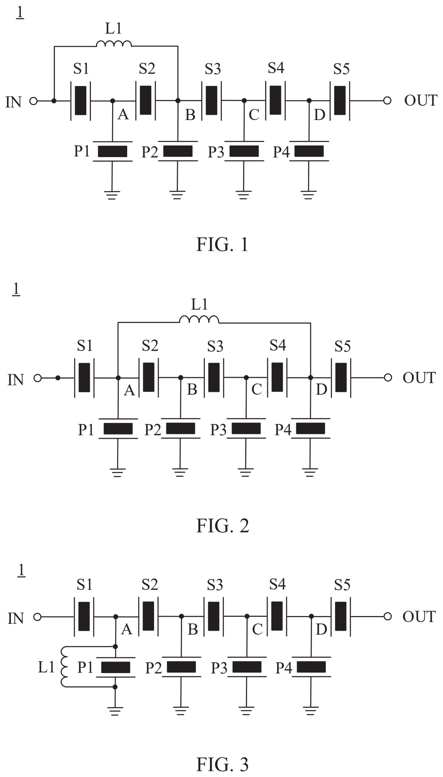

To overcome the foregoing disadvantages, an embodiment of this application provides a filter circuit 1, as shown in FIG. 1. The filter circuit 1 may include a plurality of parallel resonant branches (Parallel Resonators, or Shunt Resonators) and a plurality of series resonators (Series Resonators). The plurality of series resonators may be sequentially connected in series, to form a series resonant branch. Each parallel resonant branch may include at least one parallel resonator. In embodiments of this application, an acoustic filter circuit is used as an example. The resonator in the series resonant branch is defined as a series resonator, and the resonator in the parallel resonant branch is defined as a parallel resonator.

Optionally, the plurality of parallel resonant branches and the plurality of series resonators may be disposed based on an N^{th}-order ladder topology (Ladder Topology), where N may be a quantity of parallel resonant branches. In other words, in embodiments of this application, an order of the ladder topology structure is defined based on the quantity of parallel resonant branches. In embodiments of this application, an example in which each parallel resonant branch may include one parallel resonator is used for description.

For example, as shown in FIG. 1, the filter circuit 1 may include nine resonators in total: a parallel resonator P1, a parallel resonator P2, a parallel resonator P3, a parallel resonator P4, a series resonator S1, a series resonator S2, a series resonator S3, a series resonator S4, and a series resonator S5 that are configured as a fourth-order topology structure. In other words, in embodiments of this application, an example in which the filter circuit 1 includes the four parallel resonators and the five series resonators is used in FIG. 1.

Optionally, the series resonator S1, the series resonator S2, the series resonator S3, the series resonator S4, and the series resonator S5 may be sequentially connected in series, to form a series resonant branch. A first end of the parallel resonator P1 may be electrically connected to a node A (namely, a first node) between the series resonator S1 and the series resonator S2, and a second end of the parallel resonator P1 may be electrically connected to a ground end. Similarly, a first end of the parallel resonator P2 may be electrically connected to a node B (namely, a first node) between the series resonator S2 and the series resonator S3, and a second end of the parallel resonator P2 may be electrically connected to the ground end. A first end of the parallel resonator P3 may be electrically connected to a node C (namely, a first node) between the series resonator S3 and the series resonator S4, and a second end of the parallel resonator P3 may be electrically connected to the ground end. A first end of the parallel resonator P4 may be electrically connected to a node D (namely, a first node) between the series resonator S4 and the series resonator S5, and a second end of the parallel resonator P4 may be electrically connected to the ground end. In other words, the first end of each parallel resonator may be electrically connected to two adjacent series resonators, and the second end of each parallel resonator may be electrically connected to the ground end.

It may be seen that the first end of each of the four parallel resonant branches may be electrically connected to two adjacent series resonators in the five series resonators, and the second end of each parallel resonant branch may be electrically connected to the ground end.

It can be further seen that the filter circuit 1 provided in this embodiment of this application may include the series resonant branch and the four parallel resonant branches. In this embodiment of this application, an example in which the first end of each of the four parallel resonant branches is electrically connected to two adjacent series resonators is used for description. It may be learned that a first end of any parallel resonant branch may alternatively be electrically connected to only a first or last series resonator in the series resonant branch. Details are not described in this embodiment of this application.

Further, the filter circuit provided in embodiments of this application may further include an inductor L1 (namely, a first inductor), as shown in FIG. 1, FIG. 2, FIG. 3, and FIG. 4.

For example, refer to FIG. 1. The inductor L1 may be connected in parallel to the series resonator S1 and the series resonator S2. In other words, the inductor L1 may be bridged between two ends of the series resonator S1 and the series resonator S2.

For another example, refer to FIG. 2. The inductor L1 may be connected in parallel to the series resonator S2, the series resonator S3, and the series resonator S4. In other words, the inductor L1 may be bridged between two ends of the series resonator S2, the series resonator S3, and the series resonator S4.

In the foregoing two examples, the inductor L1 may increase an equivalent electromechanical coupling coefficient of the series resonant branch. An electromechanical coupling coefficient of the entire filter circuit 1 is increased as the equivalent electromechanical coupling coefficient of the series resonant branch is increased, to further increase bandwidth of the filter circuit 1, and reduce an insertion loss of the filter circuit 1.

It can be seen that the inductor L1 may be connected in parallel to at least two adjacent series resonators in the five series resonators. In other words, a quantity of series resonators bridged by the inductor L1 is not limited in embodiments of this application. In addition, start series resonators (for example, the series resonator S1 in FIG. 1 and the series resonator S2 in FIG. 2) and end series resonators (for example, the series resonator S2 in FIG. 1 and the series resonator S4 in FIG. 2) that are bridged by the inductor L1 are not limited in this application.

For another example, refer to FIG. 3. The inductor L1 may be connected in parallel to the parallel resonator P1, to increase an electromechanical coupling coefficient of the parallel resonant branch in which the parallel resonator P1 is located. Therefore, the electromechanical coupling coefficient of the entire filter circuit 1 is increased as the electromechanical coupling coefficient of the parallel resonant branch is increased, to further increase the bandwidth of the filter circuit 1, and reduce the insertion loss of the filter circuit 1.

It may be learned that the inductor L1 may be connected in parallel to a parallel resonator in another parallel resonant branch. Details are not described in embodiments of this application.

In the filter circuit 1 provided in embodiments of this application, the four parallel resonant branches and the five series resonators may be disposed based on the N^{th}-order ladder topology, and each parallel resonant branch may include one parallel resonator. The inductor L1 may be connected in parallel to at least two adjacent series resonators, to increase the equivalent electromechanical coupling coefficient of the series resonant branch. The inductor L1 may be connected in parallel to a parallel resonator in any parallel resonant branch, to increase the electromechanical coupling coefficient of the parallel resonant branch. Therefore, the electromechanical coupling coefficient of the entire filter circuit 1 is increased as the equivalent electromechanical coupling coefficient of the series resonant branch or the electromechanical coupling coefficient of the parallel resonant branch is increased, to further increase the bandwidth of the filter circuit 1, and reduce the insertion loss of the filter circuit 1.

In some embodiments, the filter circuit may further include a first port and a second port. The first port may be used as an input port IN of the filter circuit 1, and the second port may be used as an output port OUT of the filter circuit 1. Alternatively, the second port may be used as an input port IN of the filter circuit 1, and the first port may be used as an output port OUT of the filter circuit 1. In embodiments of this application, an example in which the first port is an input port IN and the second port is an output port OUT is used for description. Refer to FIG. 1 to FIG. 3. The series resonator S1 may be used as a first end of the series resonant branch, and may be electrically connected to the input port IN. The series resonator S5 may be used as a second end of the series resonant branch, and may be electrically connected to the output port OUT.

In some other embodiments, the parallel resonant branch may be electrically connected between two adjacent series resonators that are in the plurality of series resonators and that are connected in parallel to the inductor L1. In other words, the parallel resonator may be electrically connected to a node between the two adjacent series resonators that are connected in parallel to the inductor L1, as shown in FIG. 1 and FIG. 2.

In FIG. 1, the two adjacent series resonators that are connected in parallel to the inductor L1 are the series resonator S1 and the series resonator S2. The series resonator S1 and the series resonator S2 are electrically connected by using the node A, and the parallel resonator P1 is electrically connected to the node A. In FIG. 1, the parallel resonator P1 can not only improve a degree of freedom of the filter circuit 1, but also prevent the series resonator S1 and the series resonator S2 from being equivalent to one series resonator, to further increase the bandwidth of the filter circuit 1, and reduce the insertion loss of the filter circuit 1.

In FIG. 2, adjacent series resonators that are connected in parallel to the inductor L1 include the series resonator S2, the series resonator S3, and the series resonator S4. The series resonator S2 and the series resonator S3 are electrically connected by using the node B, and the parallel resonator P2 is electrically connected to the node B. The series resonator S3 and the series resonator S4 are electrically connected by using the node C, and the parallel resonator P3 is electrically connected to the node C. In FIG. 2, the parallel resonator P2 and the parallel resonator P3 improve the degree of freedom of the filter circuit 1, the parallel resonator P2 can prevent the series resonator S2 and the series resonator S3 from being equivalent to one series resonator, and the parallel resonator P3 can prevent the series resonator S3 and the series resonator S4 from being equivalent to one series resonator, to further increase the bandwidth of the filter circuit 1, and reduce the insertion loss of the filter circuit 1.

In some other embodiments, each parallel resonant branch may include a plurality of parallel resonators, and the plurality of parallel resonators may be sequentially connected in series. One parallel resonant branch may be electrically connected to a node between every two adjacent series resonators.

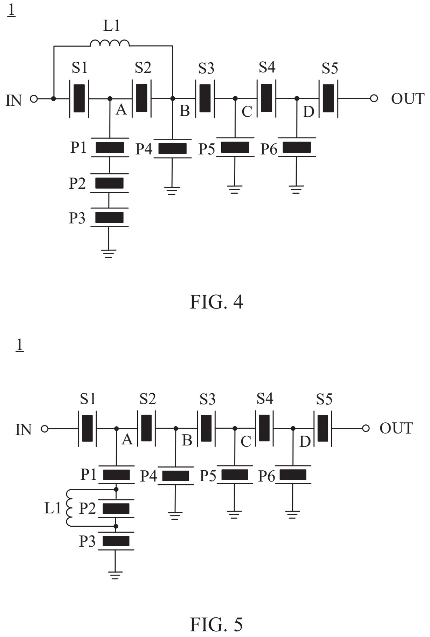

As shown in FIG. 4, a parallel resonant branch electrically connected to the node A includes the parallel resonator P1, the parallel resonator P2, and the parallel resonator P3, and the parallel resonator P1, the parallel resonator P2, and the parallel resonator P3 may be sequentially connected in series.

The parallel resonator P1 may be used as a first end of the parallel resonant branch, and the parallel resonator P3 may be used as a second end of the parallel resonant branch. The parallel resonator P1 may be electrically connected to the node A, and the parallel resonator P3 may be electrically connected to the ground end. The first end of the parallel resonator P4 may be electrically connected to the node B, a first end of a parallel resonator P5 may be electrically connected to the node C, a first end of a parallel resonator P6 may be electrically connected to the node D, and a second end of each of the parallel resonator P4, the parallel resonator P5, and the parallel resonator P6 may be electrically connected to the ground end.

It can be seen from FIG. 4 that, in the filter circuit 1 provided in this embodiment of this application, the parallel resonant branch including the plurality of parallel resonators that are connected in series may be electrically connected between the ground end and a node between two adjacent series resonators. The plurality of parallel resonators connected in series can increase an equivalent electromechanical coupling coefficient of the parallel resonant branch, to further increase the bandwidth of the filter circuit 1, and reduce the insertion loss of the filter circuit 1.

In some embodiments, the inductor L1 may be connected in parallel to at least one of the parallel resonator P1, the parallel resonator P2, and the parallel resonator P3, to increase the equivalent electromechanical coupling coefficient of the parallel resonant branch. Therefore, the electromechanical coupling coefficient of the entire filter circuit 1 is increased, to further increase the bandwidth of the filter circuit 1, and reduce the insertion loss of the filter circuit 1.

For example, the inductor L1 may be connected in parallel to the parallel resonator P2, as shown in FIG. 5.

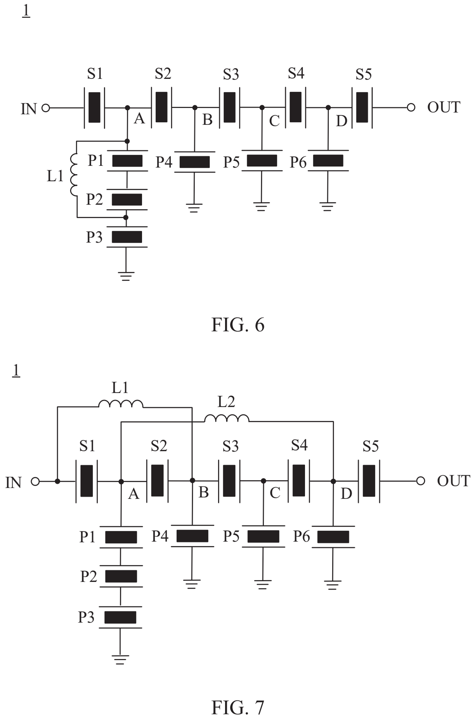

For another example, the inductor L1 may be connected in parallel to the parallel resonator P1 and the parallel resonator P2, as shown in FIG. 6.

For another example, the inductor L1 may be connected in parallel to the parallel resonator P1, the parallel resonator P2, and the parallel resonator P3.

It may be learned that, in FIG. 5 and FIG. 6, the inductor L1 may be further connected in parallel to the parallel resonator P4, the parallel resonator P5, or the parallel resonator P6. Details are not described in embodiments of this application.

Further, the inductor L1 may be connected in parallel to at least one parallel resonator in the parallel resonator P1, the parallel resonator P2, and the parallel resonator P3 other than the parallel resonator P3 electrically connected to the ground end. In other words, the inductor L1 may be connected in parallel to at least one of the parallel resonator P1 and the parallel resonator P2. This can prevent a plurality of parallel resonators connected in parallel to the inductor L1 from being equivalent to one parallel resonator, to further increase the bandwidth of the filter circuit 1, and reduce the insertion loss of the filter circuit 1.

The filter circuit 1 provided in embodiments of this application may further include an inductor L2 (namely, a second inductor). Similar to the inductor L1, the inductor L2 may be connected in parallel to at least two adjacent series resonators, or the inductor L2 may be connected in parallel to any parallel resonant branch. The at least two adjacent series resonators that are in the plurality of series resonators and that are connected in parallel to the inductor L2 partially overlap or do not overlap the at least two adjacent series resonators that are connected in parallel to the inductor L1.

In some embodiments, refer to FIG. 7. The inductor L2 may be connected in parallel to the series resonator S2, the series resonator S3, and the series resonator S4. The inductor L2 may increase the equivalent electromechanical coupling coefficient of the series resonant branch. The electromechanical coupling coefficient of the entire filter circuit 1 is increased as the equivalent electromechanical coupling coefficient of the series resonant branch is increased, to further increase the bandwidth of the filter circuit 1, and reduce the insertion loss of the filter circuit 1.

It may be learned that the inductor L2 may be connected in parallel to at least two adjacent series resonators in the series resonator S1, the series resonator S2, the series resonator S3, the series resonator S4, and the series resonator S5. In other words, a quantity of series resonators bridged by the inductor L2 is not limited in embodiments of this application. In addition, a start series resonator (for example, the series resonator S2 in FIG. 7) and an end series resonator (for example, the series resonator S4 in FIG. 7) that are bridged by the inductor L2 are not limited in this application.

Further, refer to FIG. 7. Series resonators connected in parallel to the inductor L1 include the series resonator S1 and the series resonator S2, and the series resonators connected in parallel to the inductor L2 include the series resonator S2, the series resonator S3, and the series resonator S4. It can be learned that both the inductor L1 and the inductor L2 may be connected in parallel to the series resonator S2. In other words, the two adjacent series resonators connected in parallel to the inductor L1 may partially overlap the three adjacent series resonators connected in parallel to the inductor L2. It may be learned that the two adjacent series resonators connected in parallel to the inductor L1 may not overlap the three adjacent series resonators connected in parallel to the inductor L2. Details are not described in this embodiment of this application.

In some other embodiments, the inductor L2 may be connected in parallel to at least one parallel resonator in the parallel resonant branch, to increase the equivalent electromechanical coupling coefficient of the parallel resonant branch. Therefore, the electromechanical coupling coefficient of the entire filter circuit 1 is increased, to further increase the bandwidth of the filter circuit 1, and reduce the insertion loss of the filter circuit 1.

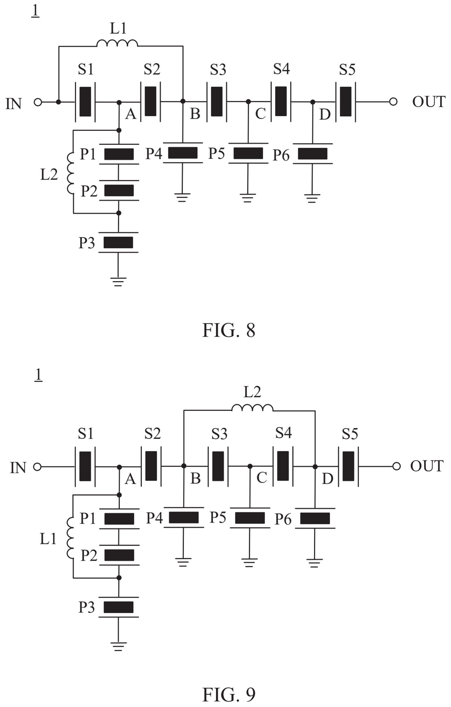

For example, refer to FIG. 8. A parallel resonant branch electrically connected to the node A may include the parallel resonator P1, the parallel resonator P2, and the parallel resonator P3. The inductor L2 may be connected in parallel to the parallel resonator P1 and the parallel resonator P2, to increase the equivalent electromechanical coupling coefficient of the parallel resonant branch. The electromechanical coupling coefficient of the entire filter circuit 1 is increased as the equivalent electromechanical coupling coefficient of the parallel resonant branch is increased, to further increase the bandwidth of the filter circuit 1, and reduce the insertion loss of the filter circuit 1.

The filter circuit 1 provided in embodiments of this application may have topology structures described in the following several examples.

For example, as shown in FIG. 7, the inductor L1 may be connected in parallel to the series resonator S1 and the series resonator S2, and the inductor L2 may be connected in parallel to the series resonator S2, the series resonator S3, and the series resonator S4. It may be learned that, to prevent the inductor L1 and the inductor L2 from being short-circuited, the inductor L1 and the inductor L2 are not electrically connected to a same node. Both the inductor L1 and the inductor L2 may increase the equivalent electromechanical coupling coefficient of the series resonant branch, to increase the electromechanical coupling coefficient of the entire filter circuit 1. This further increases the bandwidth of the filter circuit 1, and reduces the insertion loss of the filter circuit 1.

For another example, as shown in FIG. 8, the inductor L1 may be connected in parallel to the series resonator S1 and the series resonator S2, and the inductor L2 may be connected in parallel to the parallel resonator P1 and the parallel resonator P2. The inductor L1 may increase the equivalent electromechanical coupling coefficient of the series resonant branch, and the inductor L2 may increase the equivalent electromechanical coupling coefficient of the parallel resonant branch. The electromechanical coupling coefficient of the entire filter circuit 1 is increased as the equivalent electromechanical coupling coefficient of the series resonant branch and the equivalent electromechanical coupling coefficient of the parallel resonant branch are increased, to further increase the bandwidth of the filter circuit 1, and reduce the insertion loss of the filter circuit 1.

For another example, as shown in FIG. 9, the inductor L1 may be connected in parallel to the parallel resonator P1 and the parallel resonator P2, and the inductor L2 may be connected in parallel to the series resonator S3 and the series resonator S4. The inductor L1 may increase the equivalent electromechanical coupling coefficient of the parallel resonant branch, and the inductor L2 may increase the equivalent electromechanical coupling coefficient of the series resonant branch. The electromechanical coupling coefficient of the entire filter circuit 1 is increased as the equivalent electromechanical coupling coefficient of the parallel resonant branch and the equivalent electromechanical coupling coefficient of the series resonant branch are increased, to further increase the bandwidth of the filter circuit 1, and reduce the insertion loss of the filter circuit 1.

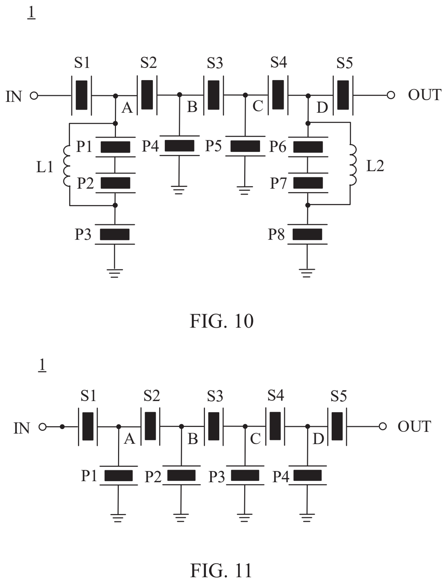

For another example, as shown in FIG. 10, the inductor L1 may be connected in parallel to the parallel resonator P1 and the parallel resonator P2, and the inductor L2 may be connected in parallel to the parallel resonator P6 and the parallel resonator P7. Both the inductor L1 and the inductor L2 may increase the equivalent electromechanical coupling coefficient of the parallel resonant branch. The electromechanical coupling coefficient of the entire filter circuit 1 is increased as the equivalent electromechanical coupling coefficient of the parallel resonant branch is increased, to further increase the bandwidth of the filter circuit 1, and reduce the insertion loss of the filter circuit 1.

For example, the parallel resonant branch may be electrically connected between two adjacent series resonators that are in the plurality of series resonators and that are connected in parallel to the inductor L2. In other words, the parallel resonator may be electrically connected to the node A between the two adjacent series resonators that are connected in parallel to the inductor L2, as shown in FIG. 7 and FIG. 9.

In FIG. 7, adjacent series resonators that are connected in parallel to the inductor L2 include the series resonator S2, the series resonator S3, and the series resonator S4. The series resonator S2 and the series resonator S3 are electrically connected by using the node B, and the parallel resonator P4 may be electrically connected to the node B. Similarly, the series resonator S3 and the series resonator S4 are electrically connected by using the node C, and the parallel resonator P5 is electrically connected to the node C. The parallel resonator P4 and the parallel resonator P5 not only improve the degree of freedom of the filter circuit 1, but also further increase the bandwidth of the filter circuit 1, and reduce the insertion loss of the filter circuit 1.

In FIG. 9, the two adjacent series resonators that are connected in parallel to the inductor L2 include the series resonator S3 and the series resonator S4. The series resonator S3 and the series resonator S4 are electrically connected by using the node C, and the parallel resonator P5 may be electrically connected to the node C. The parallel resonator P5 not only improves the degree of freedom of the filter circuit 1, but also further increases the bandwidth of the filter circuit 1, and reduces the insertion loss of the filter circuit 1.

In embodiments of this application, the filter circuit 1 is described by using the foregoing several topology structures as examples. Certainly, the filter circuit 1 may alternatively use another topology structure. This is not limited in embodiments of this application.

In some embodiments, resonance frequencies of a part or all of the series resonator S1 to the series resonator S5 in FIG. 1 to FIG. 10 are different, to lower a requirement on the resonance frequencies of the plurality of series resonators. This can further reduce production costs of the series resonators, and improve filtering performance of the filter circuit 1.

In some other embodiments, resonance frequencies of a part or all of the parallel resonator P1 to the parallel resonator P4 in FIG. 1 to FIG. 3 are different, resonance frequencies of a part or all of the parallel resonator P1 to the parallel resonator P6 in FIG. 4 to FIG. 9 are different, and resonance frequencies of some or all of the parallel resonator P1 to a parallel resonator P8 in FIG. 10 are different, to reduce a requirement on resonance frequencies of the plurality of parallel resonators. This can further reduce production costs of the parallel resonators, and improve filtering performance of the filter circuit 1.

In some other embodiments, in FIG. 1 to FIG. 3, a resonance frequency of any one of the series resonator S1 to the series resonator S5 may be different from a resonance frequency of any one of the parallel resonator P1 to the parallel resonator P4. In FIG. 4 to FIG. 9, a resonance frequency of any one of the series resonator S1 to the series resonator S5 may be different from a resonance frequency of any one of the parallel resonator P1 to the parallel resonator P6. In FIG. 10, a resonance frequency of any one of the series resonator S1 to the series resonator S5 may be different from a resonance frequency of any one of the parallel resonator P1 to the parallel resonator P8.

Further, in FIG. 1 to FIG. 3, the resonance frequency of any one of the series resonator S1 to the series resonator S5 may be greater than the resonance frequency of any one of the parallel resonator P1 to the parallel resonator P4. In FIG. 4 to FIG. 9, the resonance frequency of any one of the series resonator S1 to the series resonator S5 may be greater than the resonance frequency of any one of the parallel resonator P1 to the parallel resonator P6. In FIG. 10, the resonance frequency of any one of the series resonator S1 to the series resonator S5 may be greater than the resonance frequency of any one of the parallel resonator P1 to the parallel resonator P8. This can further improve filtering performance of the filter circuit 1.

In FIG. 1 to FIG. 3, the resonance frequency of any one of the series resonator S1 to the series resonator S5 may be greater than the resonance frequency of any one of the parallel resonator P1 to the parallel resonator P4. In FIG. 4 to FIG. 9, the resonance frequency of any one of the series resonator S1 to the series resonator S5 may be greater than the resonance frequency of any one of the parallel resonator P1 to the parallel resonator P6. In FIG. 10, the resonance frequency of any one of the series resonator S1 to the series resonator S5 may be greater than the resonance frequency of any one of the parallel resonator P1 to the parallel resonator P8. This can further improve filtering performance of the filter circuit 1.

For example, in FIG. 1 to FIG. 10, at least one series resonator may be a bulk acoustic wave (bulk acoustic wave, BAW) resonator (which may be referred to as a BAW resonator for short) or a surface acoustic wave (surface acoustic wave, SAW) resonator (SAW resonator). Similarly, at least one parallel resonator may also be a BAW resonator or a SAW resonator, to improve a degree of integration of the filter circuit 1.

For example, all series resonators and all parallel resonators are BAW resonators. In this case, the filter circuit may be referred to as a bulk acoustic wave filter circuit (which may be used as a type of acoustic filter circuit).

For another example, all series resonators and all parallel resonators are SAW resonators. In this case, the filter circuit may be referred to as a surface acoustic wave filter circuit (which may be used as another type of acoustic filter circuit).

In some possible implementations, the series resonator S1, the series resonator S2, the series resonator S3, the series resonator S4, and the series resonator S5 in FIG. 1 may have a same structure form. In other words, the series resonator S1, the series resonator S2, the series resonator S3, the series resonator S4, and the series resonator S5 have a same electromechanical coupling coefficient and a same resonance frequency.

The following describes in detail a working principle of the filter circuit 1 provided in embodiments of this application.

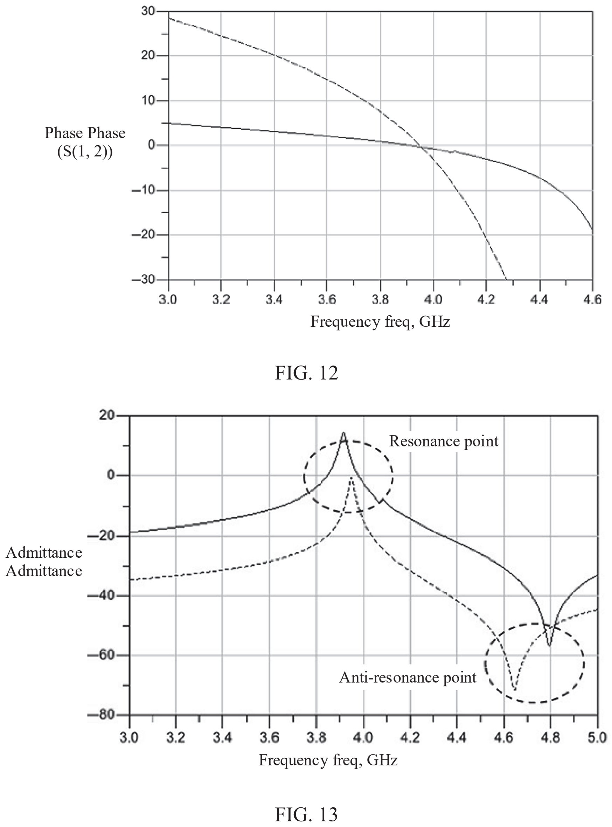

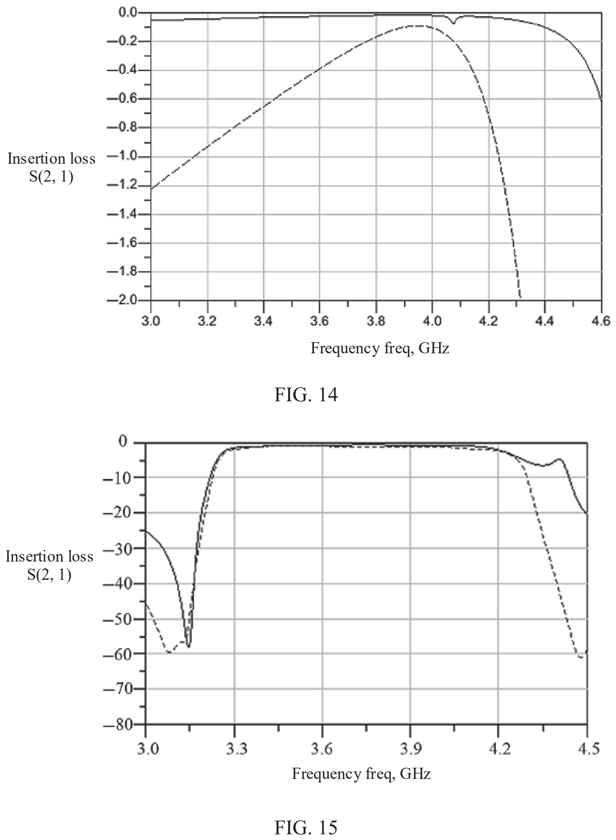

In some embodiments, simulation is separately performed on the series resonant branch that is connected in parallel to the inductor L1 in FIG. 1 and a series resonant branch that is in the filter circuit 1 and that includes the series resonator S1, the series resonator S2, the series resonator S3, the series resonator S4, and the series resonator S5 shown in FIG. 11, to obtain phase curves of the series resonant branches shown in FIG. 12, admittance curves of the series resonant branches shown in FIG. 13, and insertion loss curves of the series resonant branches shown in FIG. 14.

A solid line in FIG. 12 represents a phase curve of the series resonant branch in FIG. 1, and a dashed line represents a phase curve of the series resonant branch in FIG. 11. A solid line in FIG. 13 represents an admittance curve of the series resonant branch in FIG. 1, and a dashed line in FIG. 13 represents an admittance curve of the series resonant branch in FIG. 11. A solid line in FIG. 14 represents an insertion loss curve of the series resonant branch in FIG. 1, and a dashed line in FIG. 14 represents an insertion loss curve of the series resonant branch in FIG. 11.

It can be learned that, compared with the dashed line in FIG. 12, the solid line in FIG. 12 is smoother, indicating that the phase curve of the series resonant branch can better match the phase curve of the filter circuit 1 by using the inductor L1. This can increase the bandwidth of the filter circuit 1.

By comparing the solid line and the dashed line in FIG. 13, it can be found that a distance between a resonance point and an anti-resonance point in the solid line is wider, indicating that the inductor L1 can increase the equivalent electromechanical coupling coefficient of the series resonant branch, and can also increase the bandwidth of the filter circuit 1.

It can be learned from the solid line in FIG. 14 that, in FIG. 1, the series resonant branch connected in parallel to the inductor L1 has a small insertion loss in a wide frequency domain range. In other words, it can be learned from the solid line in FIG. 14 that, in the filter circuit 1 provided in embodiments of this application, the insertion loss of the series resonant branch connected in parallel to the inductor L1 is smaller.

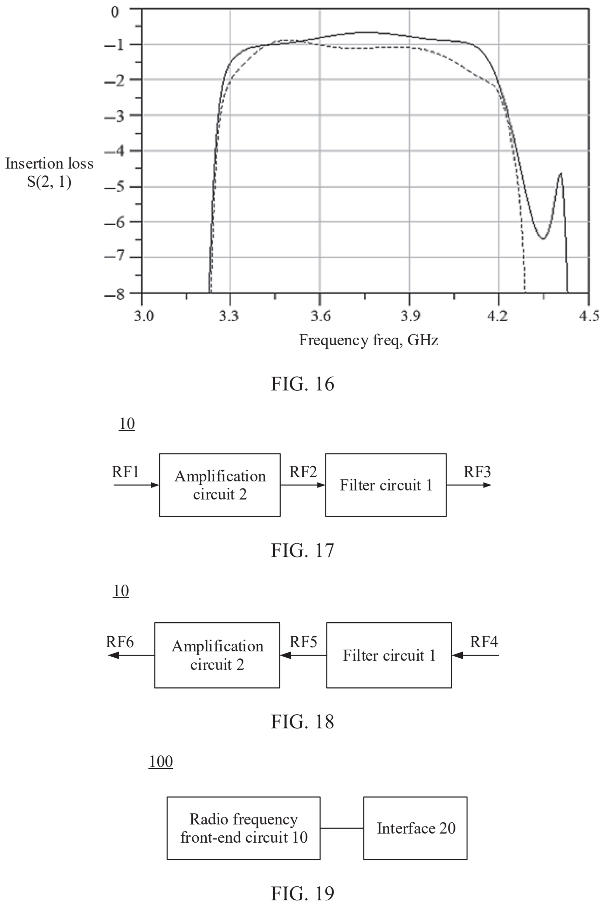

In some other embodiments, simulation is separately performed on the filter circuit 1 shown in FIG. 1 and the filter circuit 1 shown in FIG. 11, to obtain insertion loss curves of the filter circuits 1 shown in FIG. 15 and FIG. 16. FIG. 16 is a partial enlarged view of FIG. 15. In FIG. 15 and FIG. 16, a solid line represents an insertion loss curve of the filter circuit 1 shown in FIG. 1, and a dashed line represents an insertion loss curve of the filter circuit 1 shown in FIG. 11. It can be learned by comparing the solid line and the dashed line in FIG. 16 that the filter circuit 1 shown in FIG. 1 in embodiments of this application may have larger bandwidth and a lower insertion loss.

An embodiment of this application provides a radio frequency front-end circuit 10, including an amplification circuit 2 and the foregoing filter circuit 1, as shown in FIG. 17 and FIG. 18.

For example, as shown in FIG. 17, the radio frequency front-end circuit 10 is used as a transmit end, and is configured to transmit a radio frequency signal (namely, a third radio frequency signal RF3). An output end of the amplification circuit 2 may be electrically connected to an input end of the filter circuit 1. The amplification circuit 2 may be configured to amplify a first radio frequency signal RF1and transmit the amplified first radio frequency signal RF1 to the filter circuit 1. The filter circuit 1 may be configured to filter a second radio frequency signal RF2, and output a third radio frequency signal RF3. The second radio frequency signal RF2 is an amplified radio frequency signal, and the third radio frequency signal RF3 is a filtered radio frequency signal.

For another example, as shown in FIG. 18, the radio frequency front-end circuit 10 is used as a receiver end, and is configured to receive a radio frequency signal (namely, a fourth radio frequency signal RF4). An output end of the filter circuit 1 may be electrically connected to an input end of the amplification circuit 2. The filter circuit 1 may be configured to filter the fourth radio frequency signal RF4 and transmit the filtered fourth radio frequency signal RF4 to the amplification circuit 2. The amplification circuit 2 may be configured to amplify a fifth radio frequency signal RF5, and output a sixth radio frequency signal RF6. The fifth radio frequency signal RF5 is a filtered radio frequency signal, and the sixth radio frequency signal RF6 is an amplified radio frequency signal.

An embodiment of this application provides a radio frequency chip 100, as shown in FIG. 19. The radio frequency chip 100 may include an interface 20 and the radio frequency front-end circuit 10. The radio frequency front-end circuit 10 may be electrically connected to the interface 20.

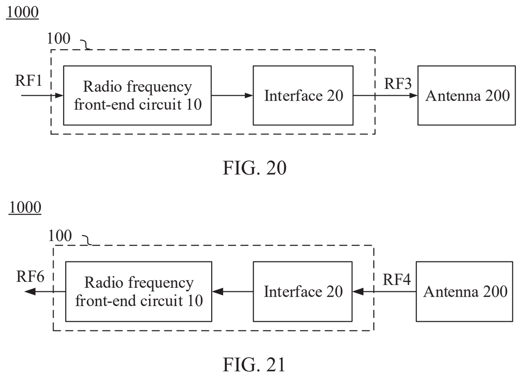

An embodiment of this application provides an electronic device 1000, as shown in FIG. 20 and FIG. 21. The electronic device 1000 may include an antenna 200 and the radio frequency chip 100. The antenna 200 may be electrically connected to the radio frequency chip 100.

For example, as shown in FIG. 20, the radio frequency chip 100 is used as a chip for transmitting the foregoing third radio frequency signal RF3. The third radio frequency signal RF3 output by the radio frequency chip 100 is transmitted to the antenna 200 through the interface 20, and is transmitted through the antenna 200.

For another example, as shown in FIG. 21, the radio frequency chip 100 is used as a chip for receiving the foregoing fourth radio frequency signal RF4. The fourth radio frequency signal RF4 received by the antenna 200 is transmitted to the radio frequency chip 100 through the interface 20, and the radio frequency chip 100 outputs the sixth radio frequency signal RF6.

Optionally, the electronic device 1000 may be a mobile phone, a notebook computer, a wearable electronic device, a vehicle-mounted device, or the like. A type of the electronic device 1000 is not limited in embodiments of this application.

The foregoing descriptions are merely specific implementations of this application, but the protection scope of this application is not limited thereto. Any variation or replacement that can be readily figured out by a person skilled in the art within the technical scope disclosed in this application shall fall within the protection scope of this application. Therefore, the protection scope of this application shall be subject to the protection scope of the claims.

## Claims

1. A filter circuit, comprising:
a plurality of parallel resonant branches and a plurality of series resonators, wherein the plurality of parallel resonant branches and the plurality of series resonators are disposed based on a ladder topology, and each of the plurality of parallel resonant branches comprises at least one parallel resonator; and
a first inductor, wherein the first inductor is connected in parallel to at least two adjacent series resonators in the plurality of series resonators, or the first inductor is connected in parallel to at least one parallel resonator in any one of the plurality of parallel resonant branches.

2. The filter circuit according to claim 1, wherein a first end of each of the plurality of parallel resonant branches is electrically connected to one series resonator or two adjacent series resonators in the plurality of series resonators, and a second end of each parallel resonant branch is electrically connected to a ground end.

3. The filter circuit according to claim 1, wherein the parallel resonant branch is electrically connected between two adjacent series resonators that are in the plurality of series resonators and that are connected in parallel to the first inductor.

4. The filter circuit according to any one of claims 1 to 3, wherein each parallel resonant branch comprises a plurality of parallel resonators, and the plurality of parallel resonators are sequentially connected in series.

5. The filter circuit according to claim 4, wherein the first inductor is connected in parallel to at least one of the plurality of parallel resonators other than a parallel resonator electrically connected to the ground end.

6. The filter circuit according to claim 4 or 5, wherein the filter circuit further comprises:
a second inductor, wherein the second inductor is connected in parallel to at least two adjacent series resonators, or the second inductor is connected in parallel to at least one parallel resonator in any parallel resonant branch, wherein
the at least two adjacent series resonators that are in the plurality of series resonators and that are connected in parallel to the second inductor partially overlap or do not overlap the at least two adjacent series resonators that are connected in parallel to the first inductor.

7. The filter circuit according to claim 6, wherein the parallel resonant branch is electrically connected between two adjacent series resonators that are in the plurality of series resonators and that are connected in parallel to the second inductor.

8. The filter circuit according to claim 6 or 7, wherein the second inductor is connected in parallel to at least one of the plurality of parallel resonators other than the parallel resonator electrically connected to the ground end.

9. The filter circuit according to any one of claims 4 to 8, wherein resonance frequencies of a part or all of the plurality of parallel resonators are different.

10. The filter circuit according to any one of claims 4 to 9, wherein a resonance frequency of any one of the plurality of series resonators is different from a resonance frequency of any one of the plurality of parallel resonators.

11. The filter circuit according to any one of claims 4 to 10, wherein the resonance frequency of any one of the plurality of series resonators is greater than the resonance frequency of any one of the plurality of parallel resonators.

12. The filter circuit according to any one of claims 1 to 11, wherein resonance frequencies of a part or all of the plurality of series resonators are different.

13. The filter circuit according to any one of claims 1 to 12, wherein at least one of the plurality of series resonators is a bulk acoustic wave resonator or a surface acoustic wave resonator; and
at least one parallel resonator is a bulk acoustic wave resonator or a surface acoustic wave resonator.

14. A radio frequency front-end circuit, comprising an amplification circuit and the filter circuit according to any one of claims 1 to 13, wherein the amplification circuit is electrically connected to the filter circuit.

15. A radio frequency chip, comprising an interface and the radio frequency front-end circuit according to claim 14 that is electrically connected to the interface.

16. An electronic device, comprising an antenna and the radio frequency chip according to claim 15, wherein the antenna is electrically connected to the radio frequency chip.
